# EUROPEAN PATENT SPECIFICATION

(11) **EP 2 276 174 B1**
(45) Date of publication and mention of the grant of the patent: **01.07.2015**
(21) Application number: 10171116.6
(22) Date of filing: 20.09.2002
(51) Int. Cl.: H03K 17/785

(54) **Transistor photoelectric conversion drive circuit**
Transistor-Treiberschaltung mit photoelektrischer Umwandlung
Circuit d'attaque de transistor à conversion photoélectrique

(43) Date of publication of application: 19.01.2011
(62) Divisional of application: 02256551.9
(73) Proprietor: Yang, Tai-Her, Si-Hu Town, Dzan-Hwa (TW)
(72) Inventor: Yang, Tai-Her, Si-Hu Town, Dzan-Hwa (TW)
(74) Representative: Wright, Howard Hugh Burnby

(56) References cited:
- EP-A1- 0 637 875
- DE-C1- 4 316 694
- TW-B- 480 820
- US-A- 4 716 513
- US-A- 4 977 329
- US-B1- 6 353 278
- PATENT ABSTRACTS OF JAPAN vol. 008, no. 277 (E-285), 18 December 1984 (1984-12-18) & JP 59, 146225, A, (MITSUBISHI DENKI KK), 22 August 1984 (1984-08-22)

## Description

### BACKGROUND OF THE INVENTION

### (a) Field of the Invention

The present invention relates to an photoelectric conversion drive circuit of a transistor, and more particularly, to one that comprised of a matching electric energy driven light emission device, e.g. an LED, a light bulb, any other type of photoelectric conversion light emission device or natural light source in the environment; an device coupled to the matching photoelectric conversion light emission device, such as an electricity storage device of an photo to electric energy crystal or a non-crystal system; and a voltage type drive electric energy that generates micro-current when subject to light, for transmission to high input resistance type of transistor, such as a micro or power type metal-oxide-silicon field effect transistor (MOSFET) or insulated gate bi-carrier transistor(IGBT) or other high input resistance transistor or a gate and emitter of a modulus for driven conduction. Meanwhile, a drive electric energy of a positive voltage is used to supply electric energy for storage by a circuit device of slave type of negative voltage so that upon cutting off, negative voltage is generated to input to gate and emitter of one or more than one high resistance transistors for facilitating the cut-off.

### (b) Description of the Prior Art:

A high input resistance transistor such as a metal-oxide-silicon field effect transistor (MOSFET) or an insulated gate bi-carrier transistor IGBT or any other type of high input resistance transistor or modulus is known as a solid-state transistor device voltage with its operation controlled by a drive voltage that has been developed only in recent years. In addition to functioning as a solid-state high power switch, the high input resistance transistor is convenient to be applied in micro-electronic logic operation or data memory storage circuit device or detection circuit device or other circuits. However, the input end for controlling the operation of the high input resistance transistor, e.g., MOSFET, IGBT or other types of high input resistance transistor or modulus is of high resistance type. The matching current of its drive signal is very small (approaching zero). Since the drive voltage must reach pre-set value to ensure of normal operation, larger resistance is observed between collector and emitter if voltage between gate and emitter gets too low, thus the high resistance input transistor may get burnt out due to increased thermal loss. Such a disadvantage makes the transistor be somehow limited when applied in the occasion with lower input voltage. A drawing of working characteristics of the high input resistance transistor using an IGBT as example is attached to this application. Preferably, the drive signal for the IGBT should not be less than 12V.

### SUMMARY OF THE INVENTION

The primary purpose of the present invention is to provide a circuit to drive a metal-oxide-silicon field effect transistor (MOSFET) or an insulated gate bi-carrier transistor (IGBT), or other type of high input resistance transistor by having an electric energy driven light emission device or an environmental light source to excite a device coupled to the photoelectric conversion light emission device or environmental light source to generate electric energy of positive voltage; and to generate negative voltage to gate and emitter of one or more than one high resistance transistor to facilitate cutting off.

### BRIEF DESCRIPTION OF THE DRAWINGS

Fig. 1 is a block chart showing a basic circuit of a photoelectric conversion drive circuit of a transistor,
Fig. 2 is a view showing that the present invention is in parallel with pressure effect system of pre-stressed structure to form a slave negative voltage supply circuit,

### DETAILED DESCRIPTION OF THE PREFERRED EMBODIMENTS

The invention is defined by the appended claims. The present invention relates to an photoelectric conversion drive circuit of a transistor, and more particularly, to one that comprised of a matching electric energy driven light emission device, e.g. an LED, a light bulb, any other type of photoelectric conversion light emission device or natural light source in the environment; an device coupled to the matching photoelectric conversion light emission device, such as an electricity storage device of an photo to electric energy crystal or a non-crystal system; and a voltage type drive electric energy that generates micro-current when subject to light, for transmission to high input resistance type of transistor, such as a micro or power type metal-oxide-silicon field effect transistor (MOSFET) or insulated gate bi-carrier transistor(IGBT) or other high input resistance transistor or a gate and emitter of a modulus for driven conduction. Meanwhile, a drive electric energy of a positive voltage is used to supply electric energy for storage by a circuit device of slave type of negative voltage so that upon cutting off, negative voltage is generated to input to gate and emitter of one or more than one high resistance transistors for facilitating the cut-off.

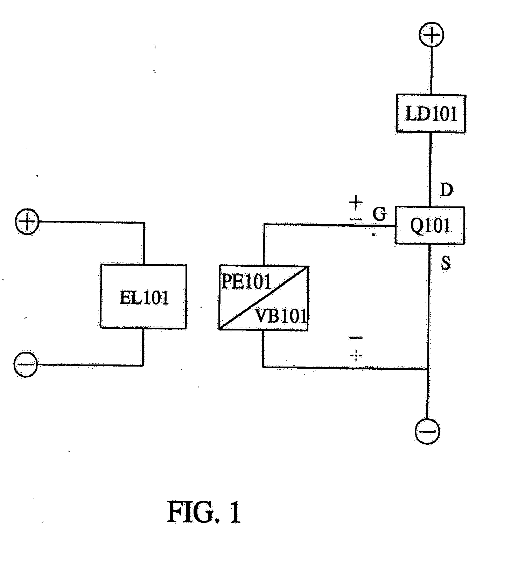

Fig. 1 is a block chart showing a basic circuit of a photoelectric conversion drive circuit of a transistor essentially comprised of:
a high input resistance transistor Q101: comprised of one or more than one various types of high input resistance transistor devices, including one-unit one-polarity or two units inversely connected in parallel, or bridge type modulus high input resistance transistor such as an active device comprised of a metal-oxide-silicon field effect transistor (MOSFET) or an insulated gate bi-carrier transistor (IGBT), or other high input resistance transistor or modulus or gate, or constitutes logic operation or data memory storage system, or detection circuit device, or constitutes other circuit that is driven by receiving electric energy drive signal of positive voltage, or one or more than one an photoelectric conversion devices PE101 is provided for joint or individual matching as may be required to drive the high input resistance transistor Q101;
a photoelectric conversion device PE101: comprised of a crystal or non-crystal system photo device that generates electric energy output when subject to light, or of other type of photoelectric conversion device to receive photo energy from an environmental light source or an electric energy driven light emission device EL101 and then the photo energy is converted into a minimum drive voltage required by the high input resistance transistor Q101 to drive the high input resistance transistor Q101; the electric energy driven light emission device EL101 comprised of one or more than one light emission diodes (LEDs), electric bulb or any other type of photoelectric conversion device is matched to the an photoelectric conversion device PE101 in such way that the photo energy outputted generates the minimum drive voltage required by the photoelectric conversion device PE101; one or more than one electric energy driven light emission devices EL101 are used to drive the photoelectric conversion device PE101; or one or more than one electric energy driven light emission device EL101 are used to jointly drive the photoelectric conversion device PE101; or two or more than two electric energy driven light emission devices EL101 are used to respectively drive the photoelectric conversion device PE101; or two or more than two electric energy driven light emission devices EL101 are used to simultaneously drive two or more than two photoelectric conversion devices PE101; and one or more than one the electric energy driven light emission devices EL101 may be provided or not provided at all depending on the requirements of the circuit;
a slave negative voltage supply circuit device VB101: comprised of solid-status or mechanic-electronic device to provide negative voltage upon cutting off for transmission to the control gate and emitter of the high input resistance transistor Q101 for facilitating the cutoff to be executed by the high input resistance transistor Q101; upon the delivery of the positive voltage electric energy signal controlling the drive, or when the photoelectric conversion device PE101 receives the photo energy emitted from the electric energy driven light emission device EL101 or from the environment to generate positive voltage to drive the high input resistance transistor Q101, the slave negative voltage supply circuit device VB101 executes storage of negative voltage at the same by means of electric energy of the inputted positive voltage signal so that when the positive voltage signal transmitting to the high input resistance transistor Q101 is interrupted, the slave negative voltage supply circuit device VB101 inputs negative voltage to the controlling gate and emitter of the high input resistance transistor Q101 to facilitate cut-off transition; the negative voltage electric energy of the slave negative voltage supply circuit device VB101 comes from a photoelectric conversion device such as the photoelectric conversion devices PE101 or an independently provided photoelectric conversion device PE102; and the negative voltage storage is characterised by a mechanic-electronic device, an inductive device, a capacity device, a (dis)chargeable secondary battery or a super capacitor, or other type of electricity storage device to store electric energy required for driving the high input resistance transistor Q101;
a loading device LD101: includes a load generating mechanical energy, photo, thermal or electrochemical effect by inputting electric energy, or any other power load comprised of resistive, capacity, inductive load or transistor or diode or any other solid-status or mechanical-electronic load device, or any circuit load functioning for post amplification, or any load for signal transmission, or any load for data storage or read-out or elimination or operation, or any load functioning as a detection circuit device or any other circuit load to be subject to the control by the high input resistance transistor Q101.

By combining those devices disclosed above, photoelectric conversion devices PE101 to generate a drive voltage under normal conditions of being subject to light in parallel, the slave negative voltage supply circuit device VB101 and the electric energy driven light emission device EL101 which can be coupled to the photoelectric conversion device PE101 such as the light emission diode (LED) or electric bulb is provided between the gate and the emitter from a high input resistance transistor such as a micro or power type metal-oxide-silicon field effect transistor (MOSFET) or an insulated gate bi-carrier transistor (IGBT) or other type of high input resistance transistor or modulus so that when the electric energy driven light emission device EL101 emits the light, or when the photoelectric conversion device PE101 is excited by the environmental light source, a relative drive voltage signal is generated to drive the high input resistance transistor Q101.

The structural configuration of the photoelectric conversion drive circuit of the transistor is described as follows:
Depending on the structural requirements, the electric energy driven light emission device EL101, the photoelectric conversion device PE101 and the slave negative voltage supply circuit device VB101 may be of individual structure, or mutually coupled, or partially or generally coupled to form a sealed configuration;
Depending on the structural requirements, the electric energy driven light emission device EL101, the photoelectric conversion device PE101 and the slave negative voltage supply circuit device VB101 may be partially or generally separately provided or packed into a modulus with the high input resistance transistor Q101;
Each and all related circuit devices may be directly connected or connected via an I/C or a PCB to form an open structure or a hybrid structure;
A drive source for the energy driven light emission device EL101referred in subparagraphs (1), (2) and (3) may be of DC or AC source to drive the bulb, or comprised of DC electric energy driven light emission diode (LED), or laser light source or other electric energy excited electric energy driven light emission device, or may be substituted with a natural light source from the environment.

The essential composition of the slave negative voltage supply circuit device VB101 provided in the photoelectric conversion drive circuit of the transistor, is characterized by that with a combination of mechanical-electronic device or solid-state device, various types of electric energy of positive voltage signal functioning as the input drive are at the same time transferred and stored in the slave negative voltage supply circuit device VB101 so to function as a negative voltage source in helping cutoff when the high input resistance transistor Q101 is cut off; it is also characterized by that by taking advantage of the photo energy generated when the electric energy driven light emission device is subject to a light for emitting the light, the photoelectric conversion device PE101 or PE102 is excited to generate the positive voltage electric energy required to drive the high input resistance transistor while the positive voltage electric energy is transferred and stored in the slave negative voltage supply circuit device VB101 so to function as the negative voltage source to help energy transformation when the high input resistance transistor Q101 is cut off; whereas the circuit structure for the formation of the slave negative voltage supply circuit device VB101 is in great number, the following preferred embodiments are given only for references to prove the feasibility of the slave negative voltage supply circuit device VB101, and do not in any way limit the scope of its composition.

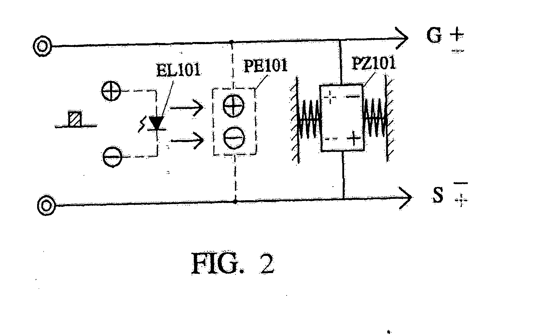

Fig. 2 shows that a slave negative voltage supply circuit is comprised of the present invention connected in parallel with a pressure effect device of pre-stressed structure. Within, a pressure effect device PZ101 of pre-stressed structure is connected in parallel between the drive signal source and the input end of the high input resistance transistor, the pressure effect device includes any device with pressure effect and is pre-compressed by means of the pre-stressed structure so that it is normally under negative voltage status when transmitted to the high input resistance transistor Q101, and the light emission device EL101 from the drive signal source is used to control the operation of the photoelectric conversion device PE101 with selected voltage coupled to it to generate electricity when subject to light for generating a positive voltage to drive the high input resistance transistor Q101; meanwhile, by taking advantage of such pressure effect, the pressure effect device PZ101 indicates its transformation in opposite to the pre-stressed direction so that when the positive voltage drive signal is interrupted, the pressure effect device PZ101 indicates a status of negative voltage against the input end of the high input resistance transistor Q101 by pre-stress restoration for improving its cutoff characteristics;

As disclosed above, the photoelectric conversion drive circuit of the transistor uses an electric energy driven light emission device or a natural light source from the environment as the working light source to control the operation of a photoelectric conversion device which when coupled to it and generates a drive voltage when subject to light and the operation of its adapted slave negative voltage supply circuit device VB101, thus to constitute a pilot drive circuit of a high input resistance transistor, such as a micro type or power type metal-oxide-silicon field effect transistor (MOSFET) or an insulated gate bi-carrier transistor (IGBT) or any other high input resistance transistor or modulus so that a high input resistance transistor, such as a micro type or power type metal-oxide-silicon field effect transistor (MOSFET) or an insulated gate bi-carrier transistor (IGBT) or any other high input resistance transistor achieves excellent control and operation either in the mode of drive or cutoff.

The slave negative voltage circuit device VB101 may have the drive signal source to drive the electric energy driven light emission device EL101 to excite the photoelectric conversion device PE101 with selected output voltage coupled to the electric energy driven light emission device EL101, and a zener diode ZD101 and the secondary electricity storage device ESD101 comprised of a capacitor or a secondary (dis)chargeable battery connected in parallel with both ends of the zener diode are connected in series between the photoelectric conversion device and the input end of the high input resistance transistor Q101 so that upon the electric energy from an external signal source is inputted, or when the photoelectric conversion device PE101 coupled as controlled by the electric energy driven light emission device EL101 generates electricity for being subject to the light to drive the high input resistance transistor Q101 through the zener diode ZD101, and to charge the secondary electricity device ESD101 in parallel with both ends of the zener diode ZD101; when the signal of positive voltage is interrupted, the secondary electricity device ESD101 indicates input of negative voltage to the input end of the high input resistance transistor Q101 to improve its cutoff characteristics; if required, the secondary resistance R500 may be connected in parallel with the output end of the photoelectric conversion device.

The slave negative voltage supply circuit device VB101 may have the drive signal source to drive the electric energy driven light emission device EL101 to excite two photoelectric conversion devices PE101 and PE102 of different values of rated output voltage connected in series of inverse polarity and indicating input polarity of negative voltage with the input end of the high input resistance transistor Q101 in the photo energy driven light emission device, the secondary electricity storage device ESD101 comprised of capacitors or the secondary (dis) chargeable battery is connected in parallel with both output ends of the photoelectric conversion device PE102 having the lower rated output voltage; upon the input of electric energy from the positive voltage signal, the electric energy driven light emission device EL101 is excited to emit light, both of the two photoelectric conversion devices PE101 containing higher rated output voltage and PE102 having the lower rated output voltage that are connected in series in inverse direction and coupled to the electric energy driven light emission device EL101 are excited to generate electricity at the same time; meanwhile the circuit indicates at the input end of the high input resistance transistor Q101 a positive voltage input of the voltage difference between the two photoelectric conversion devices PE101 and PE102 so to conduct the high input resistance transistor Q101 and to execute negative voltage charging on the secondary electricity storage device ESD101, then the electric energy is outputted through the secondary resistance R500 to the high input resistance transistor Q101 to facilitate its cut-off conduction; furthermore, the secondary resistance R500' may be connected in parallel with both ends of the secondary electricity storage device ESD101 as required by the circuit.

The slave negative voltage supply circuit device VB101 may have the drive signal source to drive the electric energy driven light emission device EL101 to excite two photoelectric conversion devices PE101 and PE102 with selected output voltage connected in series of inverse polarity and indicating input polarity of negative voltage with the input end of the high input resistance transistor Q101 in the photo energy driven light emission device, the secondary electricity storage device ESD101 comprised of capacitors or the secondary (dis)chargeable battery is connected in parallel with both output ends of the photoelectric conversion device PE102 and is further connected in parallel with the zener diode ZD101 having its zener voltage lower than the rated voltage of the photoelectric conversion device PE101; upon the input of electric energy from the positive voltage signal, the electric energy driven light emission device EL101 is excited to emit light, both of the two photoelectric conversion devices PE101 and PE102 that are connected in series in inverse direction and coupled to the electric energy driven light emission device EL101 are excited to generate electricity at the same time; meanwhile the circuit indicates at the input end of the high input resistance transistor Q101 a positive voltage input through the zener diode ZD101 to conduct the high input resistance transistor Q101 and to execute negative voltage charging on the secondary electricity storage device ESD101 connected in parallel with both ends of the zener diode; when the electric energy from the positive voltage signal is interrupted and the electric energy driven light emission device EL101 stops light emission, the electric energy of negative voltage from the secondary electricity storage device ESD101 is outputted through the secondary resistance R500 connected in parallel with both ends of the photoelectric conversion device PE101 to the high input resistance transistor Q101 to facilitate its cut-off conduction.

The slave negative voltage circuit device VB101 may have two electric energy driven light emission devices EL101 and EL102 driven by 2-way drive signal source, and two photoelectric conversion devices PE101 and PE102 with selected output voltage connected in parallel of inverse polarity and coupled to the two electric energy driven light emission devices EL101 and EL102 are used to output to the input end of the high input resistance transistor Q101. When the input signal source relates to positive conduction signal to drive the positive conduction electric energy driven light emission device EL101 to emit the light, thus to cause the photoelectric conversion device PE101 coupled to it also excited for light emission to generate electric energy of positive polarity to drive the high input resistance transistor Q101 to be conducted; when the positive signal from the input signal source is cut off and turned into negative signal, the electric energy of positive polarity outputted to the high resistance transistor is cut off while the other unit for cutoff, i.e. the electric energy driven light emission device EL102 emitting the light in inverse direction emits the light, thus to excite the photoelectric conversion device PE102 coupled to it for emitting the light to generate electric energy of negative polarity outputting to the input end of the high input resistance transistor Q101 for improving its cutoff characteristics.

The slave negative voltage supply circuit device VB101 may have the two individual electric energy driven light emission devices EL101 and EL102 driven by a 2-way drive signal source, and the two photoelectric conversion devices PE101 and PE102 provided with a selected output voltage and connected in parallel of inverse polarity are used to output to where between input ends of the high input resistance transistor Q101. When the input signal source relates to positive conduction signal to drive its matching electric energy driven light emission device EL101 to be excited for emitting the light, the photoelectric conversion device PE101 coupled to it generates electricity from receiving the light to generate electric energy of positive polarity to drive the high input resistance transistor Q101 for it to turn to be conducted; when the positive signal from the input signal source is cut off and turns into negative signal, the electric energy of positive polarity outputting to the high input resistance transistor Q101 is also cut off while the other photoelectric conversion device PE102 used also for cutoff starts to emit the light to generate electric energy of negative polarity for outputting to the input end of the high input resistance transistor Q101 to improve its cutoff characteristics.

The slave negative voltage supply circuit device VB101 may have two respectively provided electric energy driven light emission devices EL101 and EL102 driven by a two-way drive signal source, and two photoelectric conversion devices PE101 and PE102 with selected output voltage connected in series of inverse polarity and coupled to the two individual electric energy driven light emission devices EL101 and EL102 are used to output to where between the input ends of the high input resistance transistor Q101. When the input signal source relates to positive conduction signal to drive its matching electric energy driven light emission device EL101 to be excited for emitting the light, the photoelectric conversion device PE101coupled to it generates electricity from receiving the light to generate electric energy of positive polarity to drive the high input resistance transistor Q101 for it to turn to be conducted; when the positive signal from the input signal source is cut off and turns into negative signal, the electric energy of positive polarity outputting to the high input resistance transistor Q101 is also cut off while the other photoelectric conversion device PE102 used also for cutoff starts to emit the light to generate electric energy of negative polarity for outputting to the input end of the high input resistance transistor Q101 to improve its cutoff characteristics. The individual output end of the two photoelectric conversion devices connected in series of inverse polarity may be respectively connected in parallel with the resistance R500 and R500' as required.

The slave negative voltage supply circuit device VB101 may have a fixed source or a drive signal is used to drive an electric energy driven light emission device EL102 to generate photo energy for exciting the photoelectric conversion device PE102 for generating electric energy of negative polarity that is coupled to the electric energy driven light emission device EL102, while the drive signal source is directly inputted or drives to control the operation of the electric energy driven light emission device EL101 to relatively generate photo energy for exciting the photoelectric conversion device PE101 coupled to it and provided for generating electric energy of positive polarity, then the photo energy is further outputted to the input end of the high input resistance transistor Q101 with both input ends of the high input resistance transistor Q101 connected in parallel and further connected in series with a secondary resistance R700 and another resistance R700' ; and the photoelectric conversion device PE102 provided for generating electric energy of negative polarity indicates inverse polarity to be connected in parallel with the secondary resistance R700' for constantly indicating electric energy of negative polarity to the input end of the high input resistance transistor Q101. When the drive signal source is interrupted, the electric energy of positive polarity outputted to the high input resistance transistor Q101 is also cut off, the electric energy of negative polarity outputted from the photoelectric conversion device PE102 is conducted to the high input resistance transistor Q101 to improve its cutoff characteristics; the fixed source may come from a main power or a dedicated secondary power source or a secondary source shared by other source circuit.

The slave negative voltage supply circuit device VB101 may have a fixed source or a drive signal is used to drive an electric energy driven light emission device EL102 to generate photo energy for exciting the photoelectric conversion device PE102 for generating electric energy of negative polarity that is coupled to the electric energy driven light emission device EL102, while the drive signal source is directly inputted or drives to control the operation of the electric energy driven light emission device EL101 to relatively generate photo energy for exciting the photoelectric conversion device PE101 coupled to it and provided for generating electric energy of positive polarity, then the photo energy is further outputted to the input end of the high input resistance transistor Q101 with both input ends of the high input resistance transistor Q101 connected in parallel with a circuit comprised of a secondary resistance R700 and the secondary electricity device ESD101 connected in series; and the photoelectric conversion device PE102 provided for generating electric energy of negative polarity indicates inverse polarity to be connected in parallel with the secondary electricity storage device ESD101 for constantly indicating electric energy of negative polarity to the input end of the high input resistance transistor Q101. When the drive signal source is interrupted, the electric energy of positive polarity outputted to the high input resistance transistor Q101 is also cut off, the electric energy of negative polarity outputted from the photoelectric conversion device PE102 is conducted to the high input resistance transistor Q101 to improve its cutoff characteristics; the fixed source may come from a main power or a dedicated secondary power source or a secondary source shared by other source circuit and a secondary resistance R700' may be or may not be respectively provided to both ends of the photoelectric conversion device PE102.

The slave negative voltage supply circuit device VB101 may have a fixed source or a drive signal is used to drive an electric energy driven light emission device EL102 to generate photo energy for exciting the photoelectric conversion device PE102 for generating electric energy of negative polarity that is coupled to the electric energy driven light emission device EL102, while the drive signal source is directly inputted or drives to control the operation of the electric energy driven light emission device EL101 to relatively generate photo energy for exciting the photoelectric conversion device PE101 coupled to it and provided for generating electric energy of positive polarity, when both output ends of the photoelectric conversion device PE101 is connected in parallel with the secondary resistance R700, and then further connected in series with the photoelectric conversion device PE102 of inverse polarity and inputted to the input end of the high resistance transistor Q101, the voltage of rated output electric energy of the photoelectric conversion device PE102 provided for generating the electric energy of negative polarity is lower than the voltage of the rated output voltage of the photoelectric conversion device PE102 constant to its inputted electric energy of negative polarity without affecting the control by the drive signal over the operation of the high input resistance transistor Q101. When the drive signal source is interrupted, the electric energy of positive polarity outputted to the high input resistance transistor Q101 is also cut off, the electric energy of negative polarity is outputted to the high input resistance transistor Q101 to improve its cut-off characteristics; the fixed source may come from a main power or a dedicated secondary power source or a secondary source shared by other source circuit, and a secondary resistance R700' may be or may not be respectively provided to both ends of the photoelectric conversion device PE102.

The present invention also provides a transistor photoelectric conversion drive circuit for exciting a coupled photoelectric conversion device by electric energy driven light emission device or natural light source in the environment to generate electric energy of positive voltage to drive a metal-oxide silicon field-effect transistor (MOSFET) or insulated gate bipolar transistor (IGBT) or any other high input resistance transistor while electric energy is stored at a slave negative voltage supply circuit device by means of the electric energy of positive voltage so that, upon cut off of a signal of positive voltage, negative voltage is inputted to the gate and the emitter of one or more high input resistance transistors to facilitate cut-off.

## Claims

1. A photoelectric conversion drive circuit of a transistor, comprising a matching electric energy driven light emission device, and a photoelectric conversion device coupled to it, the photoelectric conversion device being operable to generate voltage type drive electric energy of micro current for to be inputted to a high input resistance transistor, such as a micro or power type metal-oxide-silicon field effect transistor or an insulated gate bi-carrier transistor, or other type of high input resistance transistor to execute a driven conduction, the high input resistance transistor constitutes a circuit that is driven by receiving an electric energy drive signal of positive voltage, the photoelectric conversion drive circuit further comprises a pressure effect device PZ101 of pre-stressed structure connected in parallel between the photoelectric conversion device and the input end of the high input resistance transistor, the pressure effect device includes any device with pressure effect and is pre-compressed by means of the pre-stressed structure so that it is normally under negative voltage status when transmitted to the high input resistance transistor Q101, and the photo energy from the light emission device EL101 is used to control the operation of the photoelectric conversion device PE101 to generate electricity when subject to light for generating a positive voltage to drive the high input resistance transistor Q101; meanwhile, by taking advantage of such pressure effect, the pressure effect device PA101 indicates its transformation in opposite to the pre-stressed direction so that when the positive voltage drive signal is interrupted, the pressure effect device PA101 indicates a status of negative voltage against the input end of the high input resistance transistor Q101 by pre-stress restoration for improving its cut-off characteristics..

2. A photoelectric conversion drive circuit of a transistor as claimed in Claim 1, wherein, depending on the structural requirements, the electric energy driven light emission device EL101, the photoelectric conversion device PE101 may be of individual structure, or mutually coupled, or partially or generally coupled to form a sealed configuration.

3. A photoelectric conversion drive circuit of a transistor as claimed in Claim 1, wherein, depending on the structural requirements, the electric energy driven light emission device EL101, the photoelectric conversion device PE101 may be partially or generally separately provided or packed into a modulus with the high input resistance transistor Q101.

4. A photoelectric conversion drive circuit of a transistor as claimed in Claim 1, wherein, each and all related circuit devices may be directly connected or connected via an IC or a PCB to form an open structure or a hybrid structure.

5. A photoelectric conversion drive circuit of a transistor as claimed in Claim 1, wherein, the drive source for the energy driven light emission device EL101 may be of DC or AC source to drive the bulb, or comprised of DC electric energy driven light emission diode , or laser light source or other electric energy excited electric energy driven light emission device.

## Patentansprüche

1. Fotoelektrische Konversions-Steuerschaltung eines Transistors, aufweisend eine dazu passende mit elektrischer Energie betriebene lichtemittierende Einrichtung und eine damit gekoppelte fotoelektrische Konversionseinrichtung, wobei die fotoelektrische Konversionseinrichtung betreibbar ist, um elektrische Steuerenergie des Spannungstyps als Mikrostrom für die Eingabe an einem Transistor mit hohem Eingangswiderstand, wie zum Beispiel einem Metall-Oxid-Silizium-Feldeffekttransistor (MOSFET) oder einem Bipolartransistor mit isolierter Gate-Elektrode, oder an einem anderen Typ eines Transistors mit hohem Eingangswiderstand zu erzeugen, um eine gesteuerte Leitung auszuführen, wobei der Transistor mit hohem Eingangswiderstand eine Schaltung darstellt, die durch den Empfang eines Steuersignals elektrischer Energie mit positiver Spannung gesteuert wird, wobei die fotoelektrische Konversions-Steuerschaltung weiter eine Druckeffekteinrichtung PZ101 mit vorbelasteter Struktur aufweist, die zwischen der fotoelektrischen Konversionseinrichtung und dem Eingangsende des Transistors mit hohem Eingangswiderstand parallel angeschlossen ist, wobei die Druckeffekteinrichtung eine beliebige Einrichtung mit Druckeffekt aufweist und mittels der vorbelasteten Struktur vorkomprimiert ist, sodass sie bei der Übertragung zum Transistor Q101 mit hohem Eingangswiderstand normalerweise einen negativen Spannungsstatus aufweist, und wobei die Fotoenergie von der lichtemittierenden Einrichtung EL101 verwendet wird, um den Betrieb der fotoelektrischen Konversionseinrichtung PE101 zum Erzeugen von Elektrizität zu steuern, wenn diese zum Erzeugen einer positiven Spannung zum Steuern des Transistors Q101 mit hohem Eingangswiderstand Licht ausgesetzt wird; wobei die Druckeffekteinrichtung PA101 durch das Ausnutzen dieses Druckeffekts bei der Unterbrechung des Steuersignals mit positiver Spannung über die Wiederherstellung des Status vor der Belastung einen Status negativer Spannung gegen das Eingangsende des Transistors Q101 mit hohem Eingangswiderstand angibt, um die Abschaltcharakteristik zu verbessern.

2. Fotoelektrische Konversions-Steuerschaltung eines Transistors nach Anspruch 1, wobei in Abhängigkeit von den strukturellen Anforderungen die mit elektrischer Energie betriebene lichtemittierende Einrichtung EL101 und die fotoelektrische Konversionseinrichtung PE101 individuelle Strukturen aufweisen oder gegenseitig gekoppelt oder teilweise oder allgemein gekoppelt sein können, um eine abgedichtete Konfiguration zu bilden.

3. Fotoelektrische Konversions-Steuerschaltung eines Transistors nach Anspruch 1, wobei in Abhängigkeit von den strukturellen Anforderungen die mit elektrischer Energie betriebene lichtemittierende Einrichtung EL101 und die fotoelektrische Konversionseinrichtung PE101 teilweise oder allgemein separat bereitgestellt oder in einem Modul mit dem Transistor Q101 mit hohem Eingangswiderstand enthalten sein können.

4. Fotoelektrische Konversions-Steuerschaltung eines Transistors nach Anspruch 1, wobei sämtliche damit zusammenhängenden Schaltungseinrichtungen direkt oder über einen IC oder eine Leiterplatte verbunden sein können, um eine offene Struktur oder eine Hybridstruktur zu bilden.

5. Fotoelektrische Konversions-Steuerschaltung eines Transistors nach Anspruch 1, wobei die Versorgungsquelle für die mit elektrischer Energie betriebene lichtemittierende Einrichtung EL101 eine DC-oder AC-Quelle zum Steuern der Lampe sein kann oder eine mit DC-Strom betriebene lichtemittierende Diode oder eine Laserlichtquelle oder eine andere mit elektrischer Energie erregte, mit elektrischer Energie betriebene lichtemittierende Einrichtung sein kann.

## Revendications

1. Circuit d'attaque de transistor à conversion photoélectrique, comprenant un dispositif émetteur de lumière activé par l'énergie électrique, et un dispositif de conversion électrique accouplé à celui-ci, le dispositif de conversion électrique étant opérationnel pour générer une énergie électrique d'attaque du type tension d'un micro-courant pour la fournir à un transistor à résistance élevée à l'entrée, tel qu'un transistor à effet de champ en métal-oxyde-silicium du type transistor de puissance ou micro-transistor ou tel qu'un transistor bipolaire à porte isolée, ou un autre type de transistor à résistance élevée à l'entrée, pour l'exécution d'une conduction activée, le transistor à résistance élevée à l'entrée constituant un circuit activé par réception d'un signal d'attaque à énergie électrique de tension positive, le circuit d'attaque à conversion photoélectrique comprenant en outre un dispositif à effet de pression PZ101 présentant une structure précontrainte reliée en parallèle entre le dispositif de conversion électrique et l'extrémité d'entrée du transistor à résistance élevée à l'entrée, le dispositif à effet de pression comprenant n'importe quel dispositif à effet de pression et étant pré-comprimé à l'aide de la structure précontrainte, de manière à se trouver normalement dans un état sous tension négative lors de la transmission au transistor à résistance élevée à l'entrée Q101, et l'énergie photoélectrique du dispositif émetteur de lumière EL101 étant utilisée pour commander le fonctionnement du dispositif de conversion électrique PE101 afin de générer de l'électricité lors de l'exposition à la lumière, pour générer une tension positive permettant d'entraîner le transistor à résistance élevée à l'entrée Q101 ; dans le même temps, profitant de cet effet de pression, le dispositif à effet de pression PA101 indique sa transformation dans une direction opposée à la direction de précontrainte, de sorte que lorsque le signal d'attaque de tension positive est interrompu, le dispositif à effet de pression PA101 indique un état de tension négative contre l'extrémité d'entrée du transistor à résistance élevée à l'entrée Q101 par restauration de la précontrainte pour améliorer ses caractéristiques de coupure.

2. Circuit d'attaque de transistor à conversion photoélectrique selon la revendication 1, dans lequel, selon les exigences structurelles, le dispositif émetteur de lumière EL101 à énergie électrique et le dispositif de conversion électrique PE101 peuvent présenter des structures individuelles ou peuvent être accouplés mutuellement, ou accouplés partiellement ou entièrement, pour former une configuration scellée.

3. Circuit d'attaque de transistor à conversion photoélectrique selon la revendication 1, dans lequel, selon les exigences structurelles, le dispositif émetteur de lumière EL101 à énergie électrique et le dispositif de conversion électrique PE101 peuvent être fournis comme des éléments partiellement ou entièrement séparés, ou peuvent être réunis dans un module avec le transistor à résistance élevée à l'entrée Q101.

4. Circuit d'attaque de transistor à conversion photoélectrique selon la revendication 1, dans lequel tous les dispositifs associés au circuit peuvent être raccordés directement ou raccordés par le biais d'un IC ou d'un PCB pour former une structure ouverte ou une structure hybride.

5. Circuit d'attaque de transistor à conversion photoélectrique selon la revendication 1, dans lequel la source d'activation pour le dispositif émetteur de lumière EL101 à énergie électrique peut être une source DC ou AC pour activer l'ampoule, ou peut être constituée d'une diode électroluminescente à énergie électrique DC, ou être une source de lumière laser ou un autre dispositif émetteur de lumière activé par l'énergie électrique et excité par l'énergie électrique.
